(19) Europäisches Patentamt
European Patent Office
Office européen des brevets

(11) Publication number: **0 407 781 A2**

# (12) EUROPEAN PATENT APPLICATION

(21) Application number: **90111828.1**

(22) Date of filing: **22.06.90**

(51) Int. Cl.[5]: **C08J 5/24**, C08J 3/09, B32B 27/28, //C08L79:08

(30) Priority: **10.07.89 US 377651**

(43) Date of publication of application: **16.01.91 Bulletin 91/03**

(84) Designated Contracting States: **DE ES FR GB IT SE**

(71) Applicant: **GENERAL ELECTRIC COMPANY**
**1 River Road**
**Schenectady New York 12305(US)**

(72) Inventor: **Davis, Michael John**
**1315 Moccasin Lane**
**Coshocton, Ohio 43812(US)**
Inventor: **Tracy, James Estel**
**7601 Cooks Hill Road, S.E.**
**Glenford, Ohio 43739(US)**

(74) Representative: **Catherine, Alain**
**General Electric France Service de Propriété Industrielle 18 Rue Horace Vernet**
**F-92136 Issy-Les-Moulineaux Cedex(FR)**

## (54) Polyetherimide precursor reinforced laminates and the preparation thereof.

(57) The present invention is directed to the manufacture of polyetherimide resin reinforced laminates where their production is via conventional prepreg processing techniques. Broadly, then, the present invention is directed to a method for making a reinforced prepreg of polyetherimide-forming resin. The method comprises forming a solvent solution of a polyetheramide acid and immersing a web of reinforcement in said solution. The immersed web then is withdrawn and heated to evaporate the solvent and form the prepreg. Complete conversion ofthe polyamic acid to polyetherimide may be effected in a treater oven capable of maintaining a suitably high temperature required for the particular polyamic acid used (e.g. around 300° C); otherwise pre-conditioning the prepreg in a separate heating unit is desirable. Thereafter, the prepreg can be laminated to metal foil, optionally with additional prepregs. The laminate is formed by heating said prepreg and metal foil under pressure for a time adequate to bond the foil.

EP 0 407 781 A2

# POLYETHERIMIDE PRECURSOR REINFORCED LAMINATES AND THE PREPARATION THEREOF

## Background of the Invention

The present invention relates to the production of reinforced laminates such as used in circuit board manufacture and more particularly to the use of a polyetherimide precursor therefor.

Metal-clad boards, particularly such boards for use in fabricating printed circuits, are well known in the art. The simplest of such boards generally comprises a resinous plastic substrate to which Is bonded at least one thin sheet of an electrically conductive material, preferably copper. The resinous plastic substrate can be clad with the metal foil on one or both sides, depending upon its desired use, and can be rigid or flexible depending upon the composition of the resinous plastic substrate, the choice of reinforcement (if any), and the use to which the board is to be put.

In preparing rigid metal-clad boards, it is common to form individual lamina, commonly called prepregs, by formulating a resinous binder composition made from epoxy, modified styrene, or the like. A solvent solution of the resin is placed in an apparatus known as a "dip tank". Continuous webs of reinforcement can be preimpregnated in the tank and then dried in a vertical or horizontal treating tower or oven. Normally, the resin is partially cured or B-staged after exiting the treater tower or oven. The copper foil, optionally coated with an adhesive, is placed on one side of the prepreg and subjected to heating under pressure to effect a bond between the metal foil and the substrate. Multiple prepregs can be used in forming a single composite board. Additionally, multilayer printed wiring boards will have a number of interposed laminae and copper sheets.

Pressing of the boards can be effected in a press by placing the foil/substrate structure between the platens and closing the press, or a continuous belt press can be used. The curing cycle in the press will depend upon nature and thickness of the laminate, the time and temperature of the cycle being those required to cure the substrate and the bonding adhesive layer, if present. Sufficient pressure is required to effect adequate flow of the adhesive and/or substrate resins in order to wet-out and bond adequately. The pressure must be sufficient to prevent blistering which is due to the release of gases resulting either from retained volatiles in the substrate or adhesive layers, or resulting from by-products of the curing process.

Heretofore, polyetherimide sheets have been proposed as substrates to which copper can be clad in the formation of printed circuit boards. Reinforced composite structures also have been made utilizing polyetherimide resins. U.S. Pat. No. 4,297,385 shows the use of a polyetheramide acid for coating metals. US. Pat. No. 4,118,535 shows the use of a polyetheramide acid plus an epoxy for forming coatings for metals. U.S. Pat. No. 3,682,960 shows the use of poly bis(4-aminophenyl) ether pyromellitamide plus a copolymer of trimellitic anhydride and methylene dianiline for forming coatings for metals. U.S. Pat. No. 4,562,119 shows a siloxane-modified polyamide, polyimide, or polyamide-imide curable coating for metals.

Despite these proposals in the art, it would be convenient to retain the advantages offered by polyetherimide resins in electrical laminate construction, yet retain the conventional processing that manufacturers are familiar with in B-stage prepreg production facilities.

## Broad Statement of the Invention

The present invention is directed to the manufacture of polyetherimide resin reinforced laminates where their production Is via conventional prepreg processing techniques. Broadly, then, the present invention is directed to a method for making a reinforced prepreg of polyetherimide-forming resin. The method comprises forming a solvent solution of a polyamic acid and immersing a web of reinforcement in said solution. The immersed web then is withdrawn and heated to evaporate the solvent and form the prepreg. Complete conversion of the polyamic acid to polyetherimide may be effected in a treater oven capable of maintaining a suitably high temperature required for the particular polyamic acid used (e.g. 300 °C); otherwise pre-conditioning the prepreg in a separate heating unit is desirable. Thereafter, the prepreg can be laminated to metal foil, optionally with additional prepregs. The laminate is formed by heating said prepreg and metal foil under pressure for a time adequate to bond the foil.

Advantageously, the thus-formed prepreg is heated under pressure for final conversion of residual polyamic acid into polyetherimide. Optionally, the solvent solution of polyamic acid may contain polyetherimide itself.

Advantages of the present invention include the formation of a pseudo "B-stage" prepreg with treating characteristics similar to those encountered utilizing conventional prepreg processing. Another advantage is

the ability to utilize conventional fillers. A further invention is the ability to utilize a variety of reinforcements. Yet another advantage is the fact that the polyetherimide when formed Is thermoplastic, thus it is reflowable for minimizing microvoid defects when bonded to metal foil. Yet another advantage is the ability to recycle scrap. These and other advantages will be readily apparent to those skilled in the art based upon the disclosure contained herein.

## Detailed Description of the Invention

While a variety of polyetherimides are known in the art, the preferred polyetherimides are prepared by reacting an organic diamine with an aromatic bis(ether dicarbonyl), i.e. an aromatic bis(ether anhydride) or an aromatic bis(ether dicarboxylic acid). Such polyetherimides are shown, for example, in U.S. Pats. Nos. 3,803,805, 3,787,364, 3,917,643, and 3,847,867. While a variety of techniques are used to synthesize such polyetherimides, as the present invention functions with a precursor, reference is made to U.S. Pat. No. 4,689,391 which discloses a preferred process for synthesizing the polyamide acid precursors of the preferred polyetherimides. As disclosed therein, such polyamic acids are prepared by reacting an aromatic bis(ether) anhydride of the formula

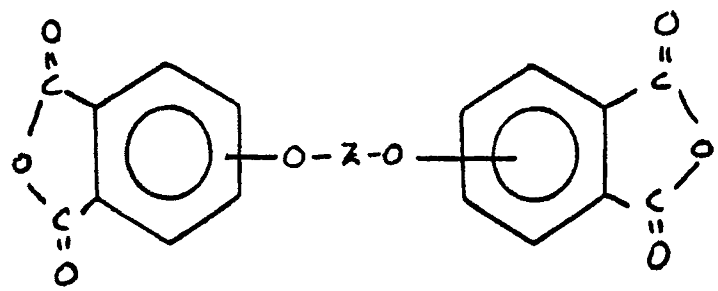

(I)

with at least one organic diamine having the formula

$H_2N\text{-}R\text{-}NH_2$ (II)

in solution under polyamide acid-forming conditions, wherein Z is a member selected from the group consisting of (A) divalent organic radicals of the formula:

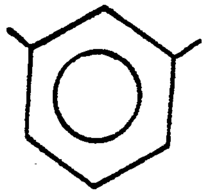

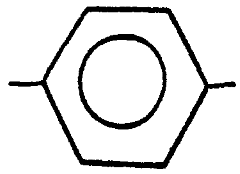

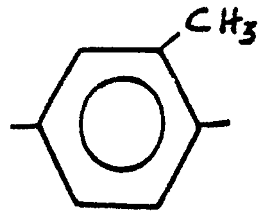

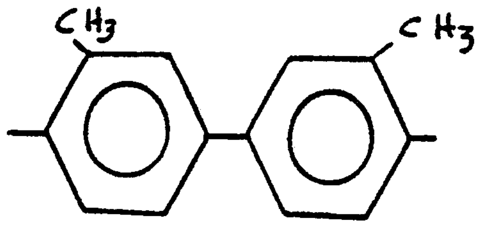

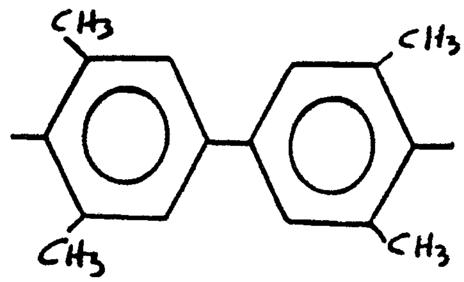

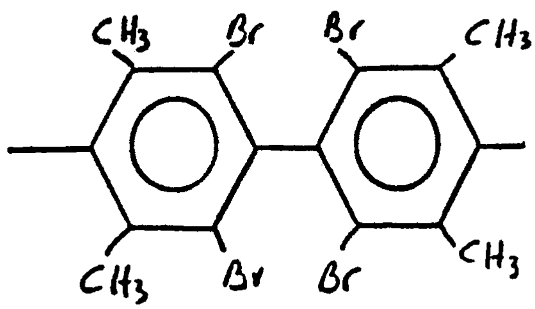

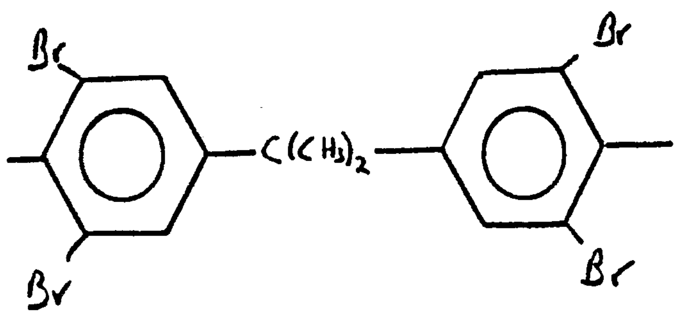

and (b) divalent radicals of the general formula

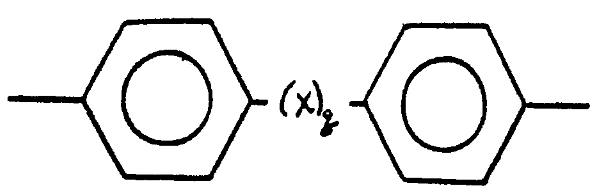

where X is a member selected from the group consisting of divalent radicals of the formulas

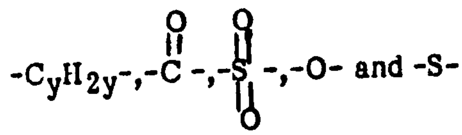

where y is an integer from 1 to about 5; and R is a divalent organic radical selected from the group consisting of (a) aromatic hydrocarbon radicals having from 6 to about 20 carbon atoms and halogenated derivatives thereof, (b) alkylene radicals having from 2 to about 20 carbon atoms, (c) from $C_2$ to about $C_8$ alkylene terminated polydiorganosiloxane, and (d) divalent radicals of the general formula

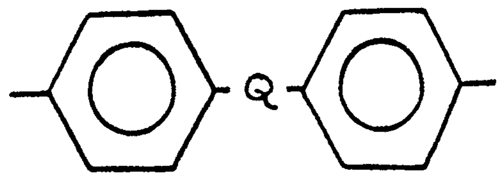

where Q is a member selected from the group of consisting of:

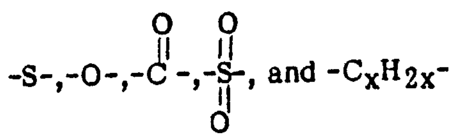

and x is an integer from about 1 to about 5.

Bis(ether anhydride)s of the formula I include, for example,
1,3-bis(2,3-dicarboxyphenoxy)benzene dianhydride;
1,4-bis(2,3-dicarboxyphenoxy)benzene dianhydride;
1,3-bis(3,4-dicarboxyphenoxy)benzene dianhydride; and
1,4-bis(3,4-dicarboxyphenoxy)benzene dianhydide.

A preferrred class of aromatic bis(ether anhydride)s included by formula I includes compounds of formulas III, IV, and V, which follow:

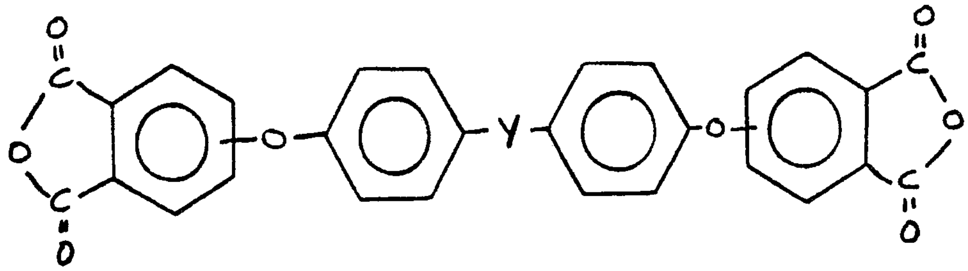

(III)

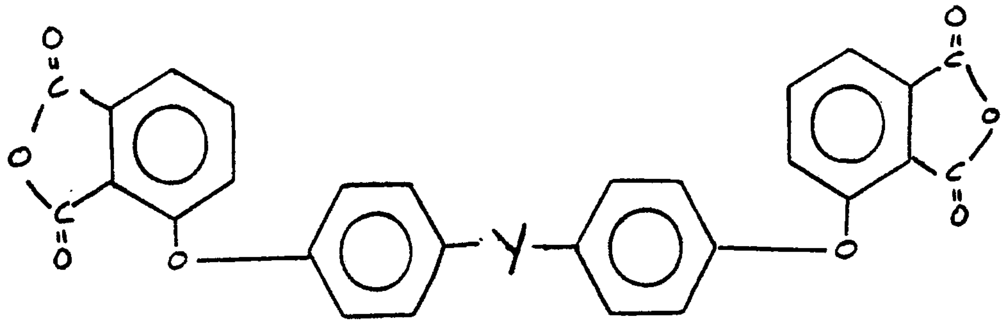

(IV)

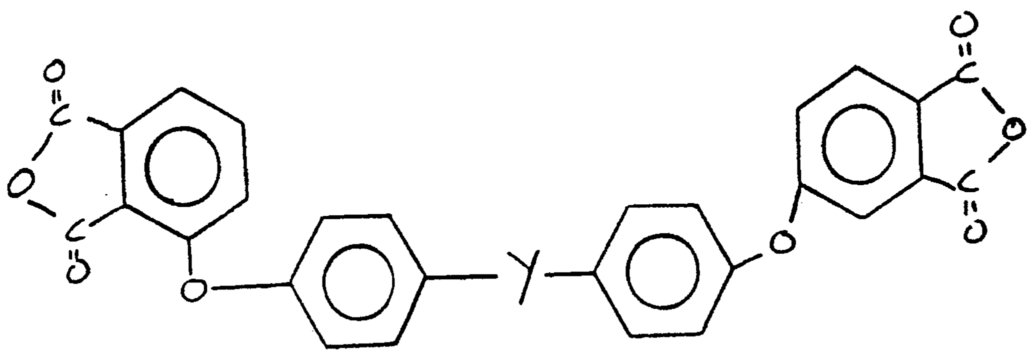

(V)

and mixtures thereof, where Y is selected from the group consisting of -O-, -S-,

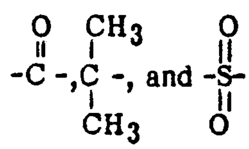

and

Aromatic bis(ether anhydride)s of formula III include, for example:
2,2-bis[4-(3,4-dicarboxyphenoxy)phenyl]propane dianhydride;
4,4′-bis(3,4-dicarboxyphenoxy)diphenyl ether dianhydride;
4,4′-bis(3,4-dicarboxyphenoxy)diphenyl sulfide dianhydride;
4,4′-bis(3,4-dicarboxyphenoxy)benzophenone dianhydride;
4,4′-bis(3,4-dicarboxyphenoxy)diphenyl sulfone dianhydride; and mixtures thereof.

Aromatic bis(ether anhydride)s of formula IV include, for example:
2,2-bis[4-(2,3-dicarboxyphenoxy)phenyl]propane dianhydride;
4,4′-bis(2,3-dicarboxyphenoxy)diphenyl ether dianhydride;
4,4′-bis(2,3-dicarboxyphenoxy)diphenyl sulfide dianhydride;
4,4′-bis(2,3-dicarboxyphenoxy)benzophenone dianhydride;
4,4′-bis(2,3-dicarboxyphenoxy)diphenyl sulfone dianhydride; and mixtures thereof.

The aromatic bis(ether anhydride) of formula V may be, for example,
4-(2,3-dicarboxyphenoxy)-4′-(3,4-dicarboxyphenoxy) diphenyl-2-2-propane dianhydride.

Some of the aromatic bis(ether anhydride)s of formula (I) are shown in U.S. Pat. No. 3,972,902. As described therein, the bis(ether anhydride)s can be prepared by the hydrolysis followed by dehydration, of the reaction product of a nitrosubstituted phenyl dinitrile with a metal salt of a dihydric phenol compound in the presence of dipolar aprotic solvent.

Additional aromatic bis(ether anhydride)s also included by Formula (I) are shown by Koton, M.D., Florinski, FS, Besonov, M.I., Rudakov, A.P. (Institue of Heteroorganic Compounds, Academy of Sciences, U.S.S.R.), U.S.S.R. 257,1010, Nov. 11, 1969, Appj. May 3, 1967, and by M.M. Koton, F.S. Florinski, Zh, Org. Khin. 4(5), 774 (1968).

Other dianhydrides may also be used in combination with the cdianhydrides of Formula I to form copolymers. Examples of such dianhydrides include pyromellitic dianhydride, sulfur dianhydride, benzophenone dianhydride and the like.

The organic diamines of Formula (II) include, for example:
m-phenylenediamine,
p-phenylenediamine,
4-4′-diaminodiphenylpropane,
4-4′-diaminodiphenylmethane (commonly named 4,4′-methylenedianiline).
4,4′-diaminodiphenyl sulfide,
4,4′-diaminodiphenyl sulfone,
4,4′-diaminodiphenyl ether (commonly named 4,4′-oxydianiline),
1,5-diaminonaphthalene,
3,3′-dimethylbenzidine,
3,3′-dimethoxybenzidine;
2,4-bis(β-amino-t-butyl)toluene,
bis(p-β-amino-t-butylphenyl)ether,
bis(p-β-methyl-o-aminopentyl)benzene,
1,3-diamino-4-isopropylbenzene,
1,2-bis(3-aminopropoxy)ethane, benzidine,
m-xylylenediamine,
p-xylylenediamine,
2,4-diaminotoluene
2,6-diaminotoluene,
bis(4-aminocyclohexyl)methane; 3-methyheptamethylenediamine,
4,4-dimethylheptamethylenediamine;
2,11-dodecanediamine,
2,2-dimethylpropylenediamine, octamethylenediamine,
3-methoxyhexamethylenediamine;
2,5-dimethylhexamethylenediamine,
2,5-dimethylheptamethylenediamine,
3-methylheptamethylenediamine,
5-methylnonamethylenediamine,
1,4-cyclohexanediamine,
1,12-octadecanediamine,
bis(3-aminopropyl)sulfide
N-methyl-bis(3-aminopropyl)amine,
hexamethylenediamine,
heptamethylenediamine,
nonamethylenediamine,
decamethylenediamine,
bis(3-aminopropyl)tetramethyldisiloxane,
bis(4-aminobutyl)tetramethyldisiloxane, and mixtures of such diamines.

The aromatic bis(ether anhydride) and the organic diamine can be reacted in the presence of a solvent under ambient conditions to produce the polyamide acid. Generally, the reaction temperatures are from about 0° C to about 200° C with temperatures of from 15° to about 30° being preferred. In general, any reaction solvent can be used in which the reactants are sufficiently soluble and which does not react significantly with the reactants or products under the conditions employed. Solvents that can be used include aliphatic and aromatic hydrocarbons, esters, ethers, ketones, and the like. Water or mixtures of water and water-miscible solvents can also be employed. If the boiling point of the solvent (at atmospheric pressure) is lower than the reaction temperature, pressure vessels may be employed to achieve the desired

temperatures. Examples of solvents that can be used include dichloromethane, N-methylpyrrolidine, chloroform, benzene, toluene, xylene, n-octane, n-decane, acetone, methyl ethyl ketone, ethyl acetate, water and mixtures thereof. Preferred solvents are dichloromethane, acetone, and water.

The polyamide acid solution can contain fillers such as, for example, talc, clays, silica, or the like. Additionally, powdered polyetherimide resin can be contained in the solvent solution. Fillers are utilized to reduce material costs and enhance performance. The concentration of polyetheramide acid in the resin solution ranges from about 25 to 40 percent by weight typically. Fillers normally range from about 0 to 30 percent by weight.

A variety of reinforcements are appropriate for immersing in the polyetheramide acid solvent solution in the treater. Such reinforcement is in web or fabric form including plain woven fabric, twill fabric, satin weave fabric, basketweave fabric, or the like. Conventional reinforcing fiber includes, for example, E glass, S glass, quartz fiber, Nextel brand inorganic fiber, organic fiber (e.g. Kevlar brand fiber or Nomex brand fiber), and aluminum oxide or other ceramic fiber. Further on conventional fibers can be found in Handbook of Fillers and Reinforcements for Plastics , edited by Katz and Milewski, Van Rostrand Reinholt Company, Litton Educational Publishing, Inc. (1978).

The web of reinforcement, preferably from continuous rolls, is immersed in the solvent solution for a time adequate for the reinforcement fibers to be wetted. The immersed web then is withdrawn from the treater in conventional fashion and dried to evaporate the solvent therefrom and convert, fully or partially, polyamic acid to polyetherimide. The thus-formed prepreg is completely dustless and is a good approximation of a conventional B-stage prepreg. Thus, the remaining operations in handling such prepreg are practiced conventionally. This means that the prepregs can be laminated to metal foil utilizing a continuous belt press or they can be cut to size for pressing in conventional presses. Multiple plies of the prepreg can be used in conventional fashion. Additionally, plies of other prepregs can be used along with the polyetheramide acid prepregs of the present invention.

While the prepregs can be simultaneously laminated to the metal foil and cured to form a polyetherimide, the curing reaction involves a condensation reaction with consequent liberation of water. Such water can be deleterious to the metal foil. Accordingly, it is distinctly preferred that the prepregs of the present invention be converted predominately to polyetherimide before heating under pressure form a polyetherimide laminate. Since the polyetherimide is thermoplastic, during lamination, it is reflowable for filling microvoids that may otherwise form in the metal foil bonding operation. Additionally, the scrap polyetherimide can be powdered and used in other applications such as, for example, extruded glass reinforced products.

The following example shows how the present invention has been practiced, but should not be construed as limiting. In this application, all percentages and proportions are by weight and all units are in the metric system, unless otherwise expressly indicated. Also, all citations are expressly incorporated herein by reference.

## EXAMPLE

In order to demonstrate the invention, several laminates of different composition were prepared based on polyamic acid (D5005 polyamic acid, 30.0% solids by weight in N-methylpyrrolidine, GE Plastics, Pittsfield, Ma.). The formulations are set forth below:

TABLE 1

| | Sample No. (wt. parts) | | | |
|---|---|---|---|---|
| Ingredient* | 1 | 2 | 3 | 4 |
| D5005 Polyetherimide | 100 | 70 | 90 | 90 |
| Ultem 1000 | - | 30 | - | - |
| Polytetrafluoroethylene | - | - | 10 | - |
| PPO | - | - | - | 10 |

* Ultem 1000 polyetherimide, powdered from pellets, GE Plastics, Pittsfield, Ma.
Polytetrafluoroethylene, powder coating 532-5010, E.I. DuPont de Nemours and Co., Wilmington, Del.
PPO is polyphenylene oxide

The presence of additional thermoplastic fillers served to alter the electrical properties of the laminates. Various woven electrical grade glass fiber and Keylar 120 brand fibers (E.I. DuPont de Nemours and Company) were treated with the various formulations to make prepregs. Three prepregs then were sandwiched between copper foil to make the laminates (50 bar, 575 °C, 60 min.).

The following data was recorded:

TABLE 2

| Physical and Electrical Properties of Laminate | | | | | | | |
|---|---|---|---|---|---|---|---|
| Sample* | 1a | 1b | 1c | 3a | 3b | 4a | 4b |
| Reinforcement | 1116 | Kevlar 120 | Kevlar 120 | 7628 | Kevlar 120 | 1116 | Kevlar 120 |
| Copper, mm JTC treatment | 0.036 | -- | -- | 0.036 | 0.036 | 0.036 | 0.036 |
| Copper, mm, acrylic coated | -- | 0.036 | 0.036 | -- | -- | -- | -- |
| Laminate thickness (less copper), mm. | 1.02 | 0.10 | 0.20 | 0.33 | 0.20 | 0.22 | 0.23 |
| Resin content, % | 36.10 | 56.00 | 56.00 | 39.30 | 52.00 | -- | -- |
| Water absorption (24 hrs.soak at 23° C),96 | 0.19 | 1.27 | -- | -- | -- | -- | -- |
| Dielectric constant at 1 MHz.: | | | | | | | |
| Untreated | 4.57 | 3.43 | -- | 4.64 | 3.40 | 3.76 | 3.40 |
| After 24 hrs. in water at 23° C | 4.67 | 4.41 | -- | 4.71 | 3.94 | 3.93 | 3.93 |
| Dissipation factor | | | | | | | |
| Untreated | 0.008 | 0.017 | -- | 0.008 | 0.014 | 0.010 | 0.014 |
| After 24 hrs. in water at 23° C | 0.011 | 0.029 | -- | 0.010 | 0.040 | 0.015 | 0.042 |
| Perpendicular dielectric breakdown strength, volts/mil: | | | | | | | |
| Untreated | 720 | 448 | 916 | -- | 253 | 871 | 850 |
| After 48 hrs. in water at 50° C | -- | 936 | 496 | -- | -- | -- | -- |
| Peel strength, kg/cm. | | | | | | | |
| As received | 0.43 | 1.21 | 1.29 | -- | 0.46 | 1.00 | 0.89 |
| After 10s at 288° C | -- | -- | -- | -- | 0.57 | 1.00 | 0.64 |
| Seconds to blister at 260° C | 7.0 | 200 | 200 | -- | 19 | 11 | 17 |

* Sample 1a: Prepreg treated on steam heated vertical treater, conditioned 1 hr at 220° C before lamination.

* Samples 1b, c: Prepreg treated on steam heated vertical treater, conditioned 1 h at 300° C before lamination.

* Samples 3, 4: Prepreg treated on steam heated vertical treater, conditioned 2 h at 190° C before lamination.

Z-axis expansion values for laminates of composition as Samples 1b and 1c, then were determined with the following results:

TABLE 3

| Temperature °C | Expansion (PPM/°C) |
|---|---|
| 70-90 | 45 |
| 110-130 | 47 |
| 130-150 | 57 |
| 170-190 | 87 |
| 70-200 | 63 |
| 70-230 | 76 |
| Sample thickness (less copper), 1.02mm. Glass transition temperature onset ($T_g$, °C) 222. | |

The data reported herein demonstrates that electrical grade reinforced laminates can be manufactured readily based on polyamic acid.

## Claims

1. Method for making a polyetherimide-forming reinforced prepreg which comprises the steps of:
   (a) forming a solvent solution of a polyamic acid,
   (b) immersing a web of reinforcement in said polyamic acid solution;
   (c) withdrawing said immersed web; and
   (d) heating it to evaporate said solvent and form said prepreg.
2. The method of claim 1 wherem said solvent solution of step (a) contains between about 25 and 40 weight percent solids of said polyamic acid.
3. The method of claim 1 wherein said solvent of said solvent solution of step (a) is an aliphatic or aromatic hydrocarbon, ester, ether, ketone, sulfoxide, amide, halogenated aliphatic or aromatic hydrocarbon, or mixture thereof, optionally admixed with water.
4. The method of claim 1 wherein said reinforcement in step (b)is a web of glass fiber, organic fiber, metal fiber, or graphite fiber.
5. The method of claim 1 wherein said heating in step (d) is at a temperature sufficient for polyetherimide formation.
6. The method of claim 1 wherein said prepreg of step (d) is bonded to metal foil under elevated temperature and pressure.
7. The method of claim 6 wherein said foil bonded to said prepreg comprises copper.
8. The method of claim 6 wherein multiple prepregs are bonded to said metal foil.
9. The method of claim 8 wherein said foil bonded to said multiple prepregs comprises copper.
10. The prepreg prepared according to the process of claim 1.
11. The laminate prepared according to the process of claim 6.
12. The laminate prepared according to the process of claim 7.
13. The laminate prepared according to the process of claim 8.
14. The laminate prepared according to the process of claim 9.